# EUROPEAN PATENT APPLICATION

(11) **EP 2 618 356 A1**
(43) Date of publication of application: **24.07.2013**
(21) Application number: 12000298.5
(22) Date of filing: 19.01.2012
(51) Int. Cl.: H01H 71/12, G01R 15/04, G01R 15/18, H01H 33/02, G01R 15/14

(54) **Voltage and/or current sensing device for low-, medium- or high voltage switching devices**

(71) Applicant: ABB Technology AG, 8050 Zürich (CH)
(72) Inventor: Javora, Radek, 62400 Brno (CZ); Raschka, David, 66491 Ivancice (CZ)
(74) Representative: Schmidt, Karl Michael

(57) **Abstract**

The invention relates to a voltage and/or current sensing device for low-, medium- or high voltage switching devices, according to the preamble of claim 1. In order to result in a constructively enhanced measuring device with high performance for the use in switching devices, the invention is, that the sensing device comprises a first voltage sensing part (12), second voltage sensing part (14) and a current sensing part (13) arranged in a single housing (30) in a way that output wire (16) from the first voltage sensing part (12), sensing voltage at an upper terminal of the switching device, is located close to the current sensing part (13).

## Description

The invention concerns to a voltage and/or current sensing device for low-, medium- or high voltage switching devices connected to an upper and/or a lower terminal of the switching device and the ground potential, according to the preamble of claim 1.

Presently, only single current or voltage sensing devices exist for the use decribed in the preamble.

In case of sensing voltage and/or current on a disconnecting or switching device, two voltage measurements need to be installed at both ends of said switching device in order to cover both, connected and disconnected state of the device. It is sufficient to sense current only at one end of the device as the current is flowing only in case of connected state of the switching device.

Traditional approach of sensing current and voltage over switching devices uses one separate current sensing device and two separate phase-to-ground voltage sensing devices located each on different sides of the swithing device.

So it is the object of the invention, to present a constructively enhanced measuring device with high performance for the use in switching devices.

This is realized by the invention, that the sensing device comprises a first voltage sensing part, second voltage sensing part and a current sensing part arranged in a single housing in a way that output wire from the first voltage sensing part, sensing voltage at an upper terminal of the switching device, is located close to the current sensing part.

So the invention is, to present a single measuring device that enables to measure voltages on both ends of devices such as circuit breaker or disconnector. Special construction of such device allows combination of two phase-to-groud voltage measurements and current measurement into a single design.

Further embodiments are given as follows.

An advantageous embodiment is, that the second voltage sensing part is located between the current sensing part and lower terminal of the switching device.

A further advantageous detail is, that the second voltage sensing part is located in parallel to the current sensing part, and is connected between the lower terminal and the ground potential of the switching device.

A first advantageous alternative according to the type of voltage sensor is, that at least the first of the voltage sensing parts, located at the upper terminal is applied with, or arranged as resistive divider. This includes also, that both voltage sensing parts can be applied with or arranged as resistive divider.

A second alternative to that is, that the first voltage sensing part, located at the upper terminal is applied with, or arranged as resitive divider, and the second voltage sensing part located at the lower terminal is applied with, or arranged as a capacitive divider.

The use of low-power current and voltage sensing technologies as current and voltage sensing parts is advantageous.

Futhermore advantageous is, that current transformer for current sensing part and/or voltage transformer for at least one voltage sensing part are applied.

One embodiment of practical value is, that the sensing device contains of two voltage sensing parts.

For several applications it is also advantageous, that the sensing device contains one voltage sensing part and one current sensing part.

The device can be used alternatively. First alternative is, that the sensing device is applied for single phase application.

Fortunately the device can also be applied for multiple phase application, in that way, that each phase is applied with one independent sensing device.

Advantageous is the application, that in the use of the sensing device in switchgears with circuit breaker or vacuum circuit breaker, the sensing device is in the near of a pole part, which contains the vacuum circuit breaker. For this application or in general, the invention related sensing device is very compact, and so with high pratical use, in switchgear arrangements which should be compact.

According to a compact arrangement an advantageous embodiment is, that the sensing device is positioned in parallel to the circuit breaker or pole part long axis.

Furthermore the sensing device has a high practical importance for the use in disconnectors, in order to ensure also security effects.

Several examples and advantageous embodiments of the invention are shown in the figures and disclosed as follows.
Figure 1: double voltage switching device
Figure 2: double voltage sensing device with current sensing
Figure 3: compact sensing device
Figure 4: Embodiment in use with medium voltage circuit breaker
Figure 5: further embodiment
Figure 6: a further alternative arrangement of the sensors

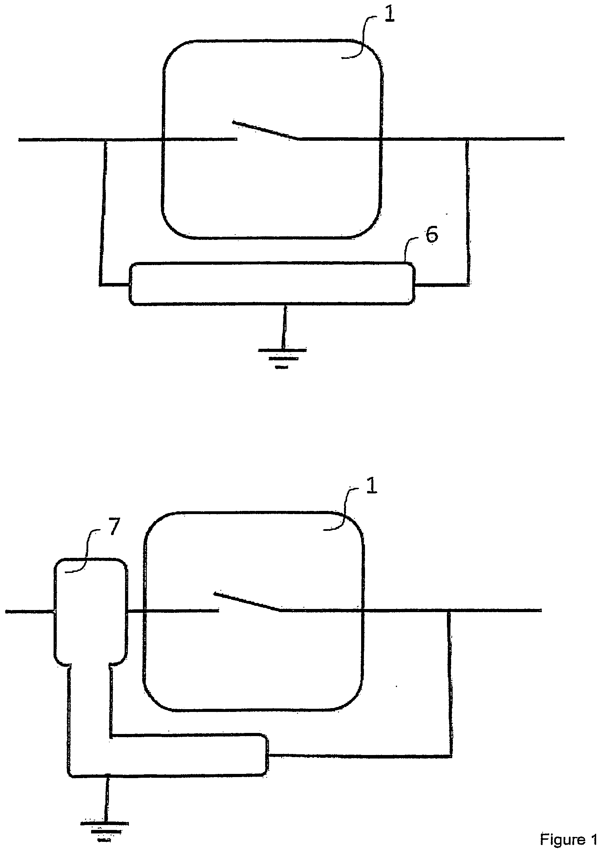

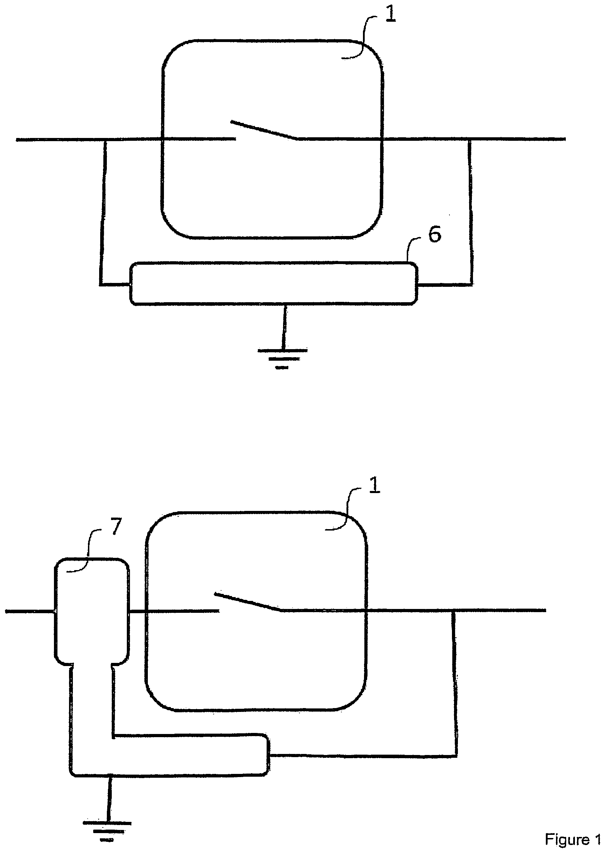

In order to eliminate the need for several sensing devices, reduce the installation costs and simplify assembly, it is proposed to integrate all sensing requirements into a single device. Such device might be either single phase device or even multiphase device. In following, only the single phase device for sensing will be described. Concept and shape of such device is shown in Fig. 1.
Fig. 1 shows a double voltage sensing device 6 over switching device 1.
It is also possible to implement a current sensing integrated inside of the same device, see bottom part of figure 1, which shows a double voltage sensing device **with** current sensing integrated 7.

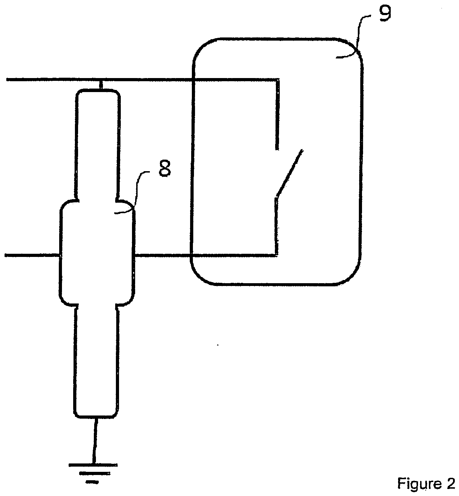

Sensing of current and voltage could be realized by different means, e.g. by conventional current and voltage instrument transformers or low-power current and voltage sensors could be used. Biggest advantage and lowest size of such solution could be prefferably achieved by low-power sensors.
Preferred design that follow the same idea as in Fig. 1 (bottom) and that is much more size optimized is described in Fig. 2. In this case the switching device is a circuit breaker that has contact arms located above each other. Such concept has less space available between the contact arms and sensing solution could be then fully optimized. Fig. 2 with a double voltage sensing device with current sensing 8 used for circuit breaker 9 solution with parallel contact arms.

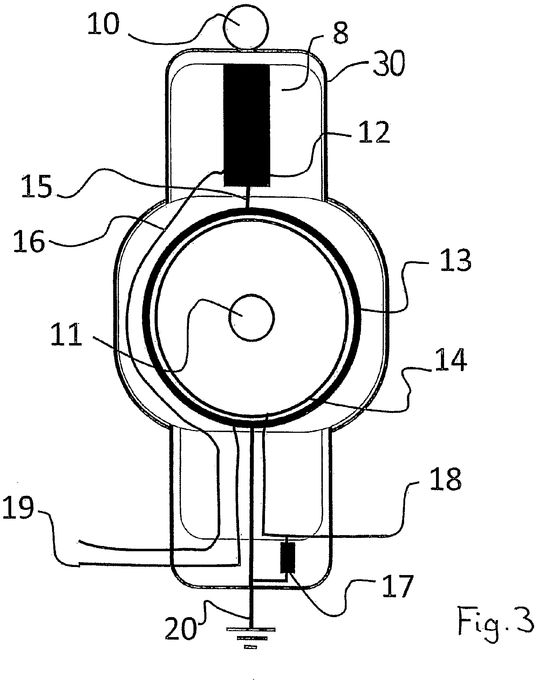

Both phase-to-ground voltage sensing parts of the device 8 needs to connect one of their end to the line voltage to be sensed and the other one to the ground potential. In order to achieve the best electrical parameters, voltage distribution between the contact arms and fully optimized space occupied, following design of the sensing device 8, which is a current sensor, integrated with double voltage sensing device, is preferred, see Fig.3.

Fig. 3 shows a construction of double voltage sensing device with integrated current sensing Fig. 3 shows a sensing device 8 comprising of first voltage sensing device 12, preferrably a resistive voltage divider, current sensing device 13, preferrably a low-power current sensor and a second voltage sensing device 14, preferably a capacitive voltage divider. Line voltage to be sensed is located at upper terminal 10 of the circuit breaker 9 and at lower terminal 11.
First voltage sensing device 12 has ground connection 15 connected to the grounded shield of current sensing device 13. Output wire 16 of the first voltage sensing device 12 is located close to the current sensing device 13, but being insulated from each other. Output from current sensing device 13 is done by means of two output wires 19. Main part of a second voltage sensing device 14 is located within a current sensing device 13, but secondary impedance 17 of a second voltage sensing device 14 is located outside. Output of a second voltage sensing device 14 is realized by output wire 18.
All outputs 16, 18 and 19 from sensing elements are insulated from each other. They might have a separate output wire or cable each, or they all could be also integrated into one output cable.
One end of both voltage sensing devices 12 and 14 has to be connected to the ground terminal 20. In case the current sensing device is electrically shielded, such shield has to be connected to the grounding terminal 20 as well.

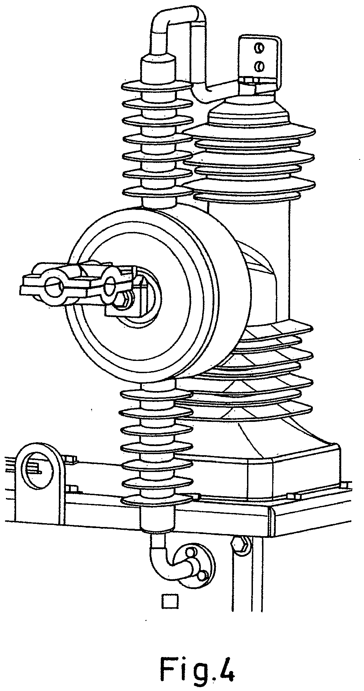

Figure 4 shows the compact and near placement of the invention related switching device in parallel to the long axis of a typical medium voltage pole part.

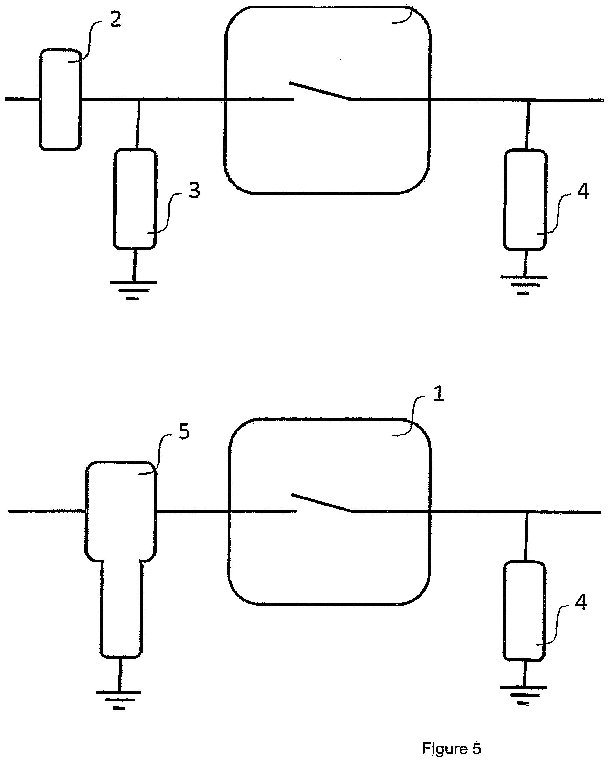

Figure 5 shows further embodiment.
Top Part of Figure 5 shows a separate current 2 and voltage 3, 4 sensing devices over the switching device 1.
Such device could be either single-phase device or the same approach could be applied in case of three-phase device as well. In that case, the same arrangement is done in all three phases.
In some cases there exists solutions using combined sensors on one side, integrating current and voltage measurement on one side into a single one-phase device. Voltage sensing on the other side requires a separate device.

Bottom part of figure 5 shows a Combined current and voltage sensing device 5, which is a combined current and voltage sensing device on one side and single voltage sensing device 4 on the other side of switching device 1.

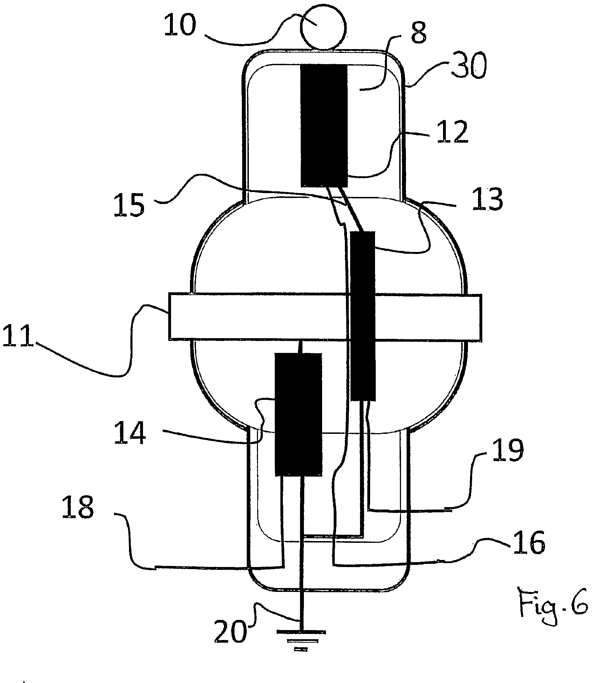

Figure 6 shows a further detailed alternative concering to the arrangement of the several sensors in the housing 30.
The second voltage sensing part 14 is located in parallel to the current sensing part 13 and it is connected between the lower terminal 11 and the ground terminal 20 of the switching device.

### Position numbers

- 1: switching device
- 2: current sensor
- 3: voltage sensor
- 4: voltage sensor
- 5: combined current and voltage sensing device
- 6: double voltage sensing device
- 7: current sensor integrated with double voltage sensing device
- 8: current sensor integrated with double voltage sensing device
- 9: circuit breaker
- 10: upper terminal
- 11: lower terminal
- 12: voltage sensing device
- 13: current sensing device
- 14: voltage sensing device
- 15: groud connection
- 16: output of sensing device
- 17: secondary impedance
- 18: output of sensing device
- 19: output of sensing device
- 20: ground terminal
- 30: housing

## Claims

1. Voltage and/or current sensing device for low-, medium- or high voltage switching devices, connected to an upper and/or a lower terminal of the switching device and the ground potential,
**characterized in**
**that** the sensing device comprises a first voltage sensing part (12), second voltage sensing part (14) and a current sensing part (13) arranged in a single housing (30) in a way that output wire (16) from the first voltage sensing part (12), sensing voltage at an upper terminal of the switching device, is located close to the current sensing part (13).

2. Voltage and/or current sensing device according to claim 1,
**characterized in**
**that** the second voltage sensing part (14) is located between the current sensing part (13) and lower terminal (11) of the switching device.

3. Voltage and/or current sensing device according to claim 1,
**characterized in**
**that** the second voltage sensing part (14) is located in parallel to the current sensing part (13), and is connected between the lower terminal (11) and the ground potential of the switching device.

4. Voltage and/or current sensing device according to one of the aforesaid claims 1 to 3,
**characterized in**
**that** at least the first of the voltage sensing parts (12), located at the upper terminal (10) is applied with, or arranged as resistive divider.

5. Voltage and/or current sensing device according to one of the aforesaid claims 1 to 3,
**characterized in**
**that** the first voltage sensing part (12), located at the upper terminal (10) is applied with, or arranged as resitive divider, and the second voltage sensing part (14) located at the lower terminal (11) is applied with, or arranged as a capacitive divider.

6. Voltage and/or current sensing device according to one of the aforesaid claims 1 to 5,
**characterized in**
the use of low-power current and voltage sensing technologies as current and voltage sensing parts.

7. Voltage and/or current sensing device according to one of the aforesaid claims 1 to 5,
**characterized in**
**that** current transformer for current sensing part and/or voltage transformer for at least one voltage sensing part are applied.

8. Voltage and/or current sensing device according to one of the aforesaid claims 1 to 5,
**characterized in**
**that** the sensing device contains of two voltage sensing parts.

9. Voltage and/or current sensing device according to one of the aforesaid claims 1 to 5,
**characterized in**
**that** the sensing device contains one voltage sensing part and one current sensing part.

10. Voltage and/or current sensing device according to one of the aforesaid claims 1 to 5,
**characterized in**
**that** the sensing device is applied for single phase application.

11. Voltage and/or current sensing device according to one of the aforesaid claims,
**characterized in**
**that** the sensing device is applied for three phase application, in that way, that each phase is applied with one independent sensing device.

12. Voltage and/or current sensing device according to one of the aforesaid claims,
**characterized in**
**that** in the use of the sensing device in switchgears with circuit breaker or vacuum circuit breaker, the sensing device is in the near of a pole part, which contains the vacuum circuit interrupter.

13. Voltage and/or current sensing device according to claim 12,
**characterized in**
**that** the sensing device is positioned in parallel to the circuit breaker or pole part long axis.

14. Voltage and/or current sensing device according to one of claim 1 to 11,
**characterized in**
**that** the sensing device is applied for a disconnector.
